# EUROPÄISCHE PATENTSCHRIFT

(11) **EP 1 108 163 B1**
(45) Veröffentlichungstag und Bekanntmachung des Hinweises auf die Patenterteilung: **06.03.2002**
(21) Anmeldenummer: 99953555.2
(22) Anmeldetag: 20.08.1999
(51) Int. Cl.: F16H 61/00

(54) **STEUERGERÄT IN EINEM KRAFTFAHRZEUG**
CONTROL DEVICE IN A MOTOR VEHICLE
DISPOSITIF DE COMMANDE POUR VEHICULE

(30) Priorität: 24.08.1998 DE 19838427
(43) Veröffentlichungstag der Anmeldung: 20.06.2001
(73) Patentinhaber: SIEMENS AKTIENGESELLSCHAFT, 80333 München (DE)
(72) Erfinder: GANDER, Helmut, D-93059 Regensburg (DE); FRITZSCHE, Christian, D-93047 Regensburg (DE)
(86) Internationale Anmeldenummer: DE9902621
(87) Internationale Veröffentlichungsnummer: WO0011376

(56) Entgegenhaltungen:
- WO-A1-95/30102
- DE-UI- 29 714 223
- DE-U1- 29 714 229
- US-A- 5 709 134

## Beschreibung

Die Erfindung betrifft ein Steuergerät gemäß dem Oberbegriff der unabhängigen Ansprüche 1 und 2.

Automatische Getriebe und Motoren für Personenkraftwagen werden überwiegend elektronisch gesteuert, wobei die elektronische Steuerung unter anderem die Signale von einem oder mehreren Sensoren im Kraftfahrzeug empfängt und auswertet. Mit einem solchen Sensor wird z. B. der Druck in dem Hydrauliköl des Getriebes oder auch der Unterdruck in dem Ansaugtrakt des Motors gemessen.

Ein bekanntes Steuergerät für ein Kraftfahrzeuggetriebe weist eine elektronische Steuerschaltung auf, die mit mindestens einem Drucksensor zum Messen des Hydraulikdrucks in dem Getriebe elektrisch verbunden ist, wobei der Drucksensor und die elektronische Steuerschaltung in einem gemeinsamen Gehäuse untergebracht sind (DE 295 13 950 U1).

Steuergeräte, die an einem oder in einem Aggregat - wie zum Beispiel dem Motor oder dem Getriebe eines Kraftfahrzeugs - montiert sind, müssen bezüglich der Abfuhr von Verlustleistung, die elektronische Bauelementen im Betrieb abgeben, wegen der hohen Umgebungstemperatur besonders sorgfältig ausgelegt werden. Druckmessende Sensoren gibt es in vielfältigen Ausführungen, zum Beispiel in Form von keramischen Druckmeßzellen, Metallmembranen mit piezoresistiven Widerständen und unterschiedliche Siliziumsensoren. Allen Ausführungen ist gemein, daß zum Erreichen der in der Automobiltechnik geforderten Genauigkeit ein Abgleich von Fertigungs- und Montagetoleranzen notwendig ist.

Da für den Abgleich von Sensorsystemen über den Druck und die Temperatur aufwendige Einrichtungen erforderlich sind, erfolgt der Abgleich üblicherweise schon bei dem Hersteller des Drucksensors.

Aus der Druckschrift DE 297 14 223 U1 ist ein Getriebesteuergerät bekannt, das eine elektronische Steuerschaltung aufweist, die mit mindestens einem Drucksensor zum Messen des Hydraulikdrucks in dem Getriebe elektrisch verbunden ist. Die elektronische Steuerschaltung und der Drucksensor sind dabei in einem gemeinsamen Steuerungsgehäuse untergebracht. Das Steuerungsgehäuse weist eine metallische Grundplatte auf, die druckdicht mit einer Hydraulikeinheit des Getriebes verbunden ist. Für den Drucksensor ist ein zusätzliches Sensorgehäuse vorgesehen.

Der Erfindung liegt das technische Problem zugrunde, ein Steuergerät zu schaffen, in das den Druck erfassende Systeme unter Berücksichtigung der vorstehend genannten Forderungen kostengünstig und zuverlässig mechanisch und elektrisch integriert sind.

Diese Aufgabe wird erfindungsgemäß durch das Steuergerät nach Anspruch 1 oder Anspruch 2 gelöst. Vorteilhafte Weiterbildungen der Erfindung sind in den Unteransprüchen niedergelegt.

Das Steuergerät weist eine elektronisch Steuerschaltung auf, die mit mindestens einem Drucksensor zum Messen des Hydraulikdrucks in dem Getriebe elektrisch verbunden ist. Der Drucksensor und die elektronische Steuerschaltung sind in einem gemeinsamen Gehäuse untergebracht, das eine metallische Grundplatte aufweist, die druckdicht mit einer Hydraulikeinheit des Getriebes verbunden ist und in die eine metallische Trägerplatte für den Drucksensor eingefügt ist. Die Trägerplatte für den Drucksensor ist mit einer Bohrung versehen, durch die der Drucksensor mit dem in der Hydraulikeinheit herrschenden Druck beaufschlagt wird. Ein metallischer Ring ist auf der in dem Gehäuse liegenden Stirnfläche der Trägerplatte befestigt, und auf dem metallischen Ring ist ein als Siliziumchip ausgebildetes Sensorelement aufgebracht. Zwischen dem metallischen Ring und dem Drucksensor kann ein Glaszylinder eingefügt sein.

Die Vorteile der Erfindung liegen insbesondere in der einfachen und kostengünstigen Integration eines Drucksensors in das druck- und fluiddichte Gehäuse einer elektronischen Steuerschaltung. Ein zusätzliches, aufwendiges Gehäuse für den Drucksensor ist nicht mehr nötig, auch die elektrischen Kontaktdurchführungen durch das Gehäuse entfallen. Der Sensor kann kostengünstig durch einfaches Bonden mit der Steuerschaltung verbunden werden. Das Gehäuse kann gegenüber der Hydraulikeinheit mit einem einfachen axialen 0-Ring abgedichtet werden.

Ausführungsbeispiele der Erfindung werden im folgenden anhand der Zeichnungen erläutert. Es zeigen:
- Figur 1: ein in ein Kraftfahrzeuggetriebe integriertes Steuergerät gemäß der Erfindung in einer Schnittansicht;
- Figur 2: das Steuergerät nach Figur 1 in der Draufsicht bei abgenommenem Deckel;
- Figur 3: ein mit einem erfindungsgemäßen Steuergerät versehenes Getriebe, in schematischer Darstellung, und
- Figur 4: ein in den Ansaugtrakt eines Kraftfahrzeugmotors eingebautes erfindungsgemäßes Steuergerät.

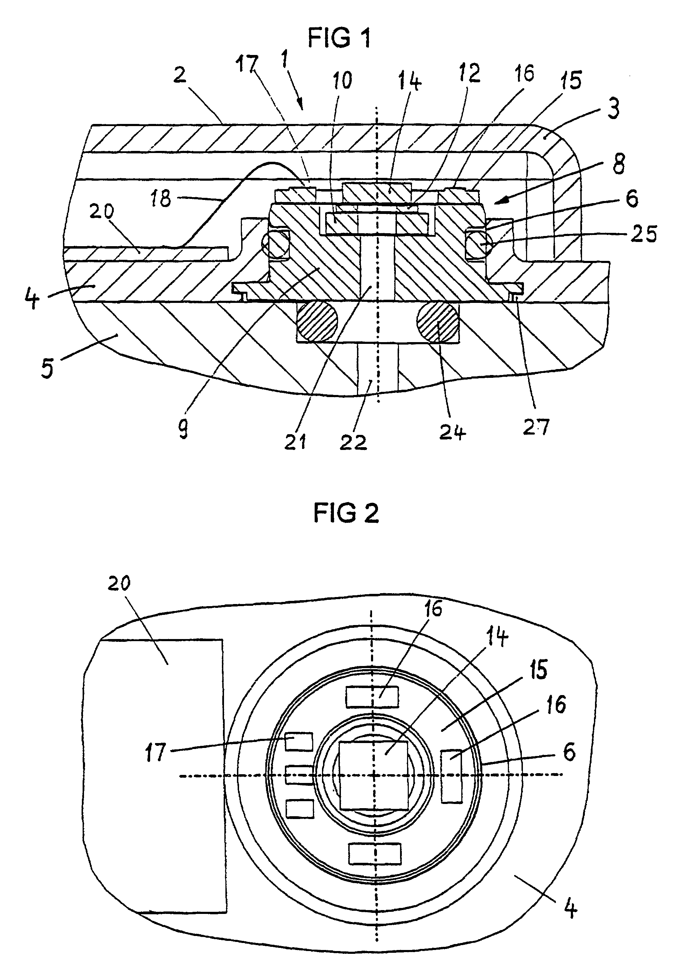

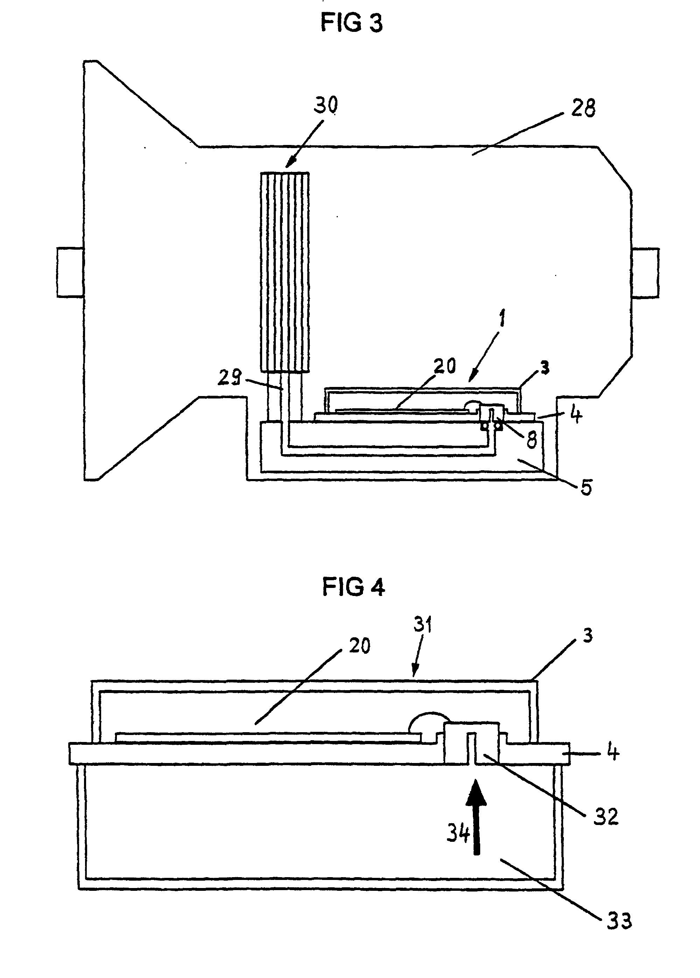

Ein in einem Kraftfahrzeug verwendetes Steuergerät 1, zum Beispiel eine Getriebesteuerung, weist ein Gehäuse 2 auf, das aus einem Deckel 3 und einer metallischen Bodenplatte 4, zum Beispiel. aus Aluminium, besteht (Figur 1). Die Bodenplatte 4 ist direkt auf einer Hydraulikeinheit 5 eines Getriebes (siehe Figur 3) befestigt. Die Bodenplatte 4 weist eine oder mehrere vorteilhafterweise kreisförmige Ausnehmungen 6 auf, die zur Aufnahme je eines Drucksensorsystems 8 dienen.

Das Drucksensorsystem 8 weist eine Trägerplatte 9 auf, die aus einem höherwertigen metallischen Werkstoff als die Bodenplatte 4, zum Beispiel aus Stahl, hergestellt ist. Auf der Trägerplatte 9 ist ein Ring 10 aus Stahl befestigt, zum Beispiel durch Widerstandsschweißen. Auf dem Ring 10 wiederum ist ein Glaszylinder 12 angeordnet, der dazu dient, mechanische Spannungen auszugleichen. Auf dem Glaszylinder 12 ist ein Drucksensor 14 befestigt, der z. B. als Siliziumchip ausgebildet ist. Falls es die Anforderungen im jeweiligen Anwendungsfall notwendig machen, kann der Ring 10 in geeigneter Weise oberflächenbehandelt, zum Beispiel mit einer Goldbeschichtung versehen werden.

Zum elektrischen Abgleich des Drucksensorsystems 8 befindet sich auf der Trägerplatte 9 ein Substrat 15, zum Beispiel aus Keramik, auf das Abgleichselemente 16, die zweckmäßigerweise als lasertrimmbare Widerstände ausgebildet sind, und Bondpads 17 aufgebracht sind.

Der Drucksensor 14 ist mit den Abgleichselementen 16 verbunden, die zum Beispiel ein Widerstandsnetz bilden. Über die Bondpads 17 und Bonddrähte 18 wird einerseits der Sensor mit Betriebsspannung versorgt und werden andererseits die Sensorsignale einer elektronischen Steuerschaltung 20 zugeführt. Verbindungsleitungen auf dem Substrat 15 sind nicht im einzelnen dargestellt, sie sind zum Beispiel als aufgedruckte Leiterbahnen ausgebildet.

Die Trägerplatte 9 weist auf eine Bohrung 21, die mit einer Bohrung 22 der Hydraulikeinheit 5 verbunden ist. Diese Bohrungen sind mit Getriebeöl gefüllt und über sie wird der Drucksensor 14 mit dem in der Hydraulikeinheit 5 herrschenden Druck beaufschlagt.

Die Trägerplatte 9 ist gegen die Hydraulikeinheit 5 durch einen axialen 0-Ring 24 abgedichtet, gegen die Ausnehmung 6 in der Grundplatte 4 ist sie mit einem radialen 0-Ring 25 abgedichtet.

Die Trägerplatte 9 ist durch ein geeignetes Verfahren gegen ein Herausfallen aus der Grundplatte 4 gesichert. Dies kann zum Beispiel durch ein Verstemmen des Werkstoffs der Grundplatte an einzelnen Stellen 27 oder auch durch ein umlaufendes Bördeln erfolgen.

An Stelle des hier beschriebenen Drucksensorsystems 8 kann auch jedes andere Sensorsystem verwendet werden, das eine Grundplatte aufweist, von seiner (in der Zeichnung) unten liegenden Seite mit Druck beaufschlagt werden kann und elektrische Kontakte an seiner Oberseite aufweist.

Ein automatisches Getriebe 28 (Figur 3) ist mit einem erfindungsgemäßen Steuergerät 1 versehen. Der in der Hydraulikeinheit 5 herrschende Druck beeinflußt direkt oder indirekt, . über einen Druckkanal 29 Brems- und Kupplungselemente 30, mit denen die Schaltvorgänge des Getriebes in bekannter Weise gesteuert werden. Indirekt bedeutet, daß der Druck beispielsweise auch über einen dazwischenliegenden, hier nicht dargestellten, Druckverstärker den Brems- und Kupplungselementen 30 zugeführt wird.

Ein anderes Ausführungsbeispiel eines erfindungsgemäßen Steuergeräts 31 dient als Motorsteuerung (Figur 4). Es weist ein Gehäuse auf, das ebenfalls aus einer Grundplatte 4 und einem kastenförmigen Deckel 3 besteht. Es enthält ein Drucksensorsystem 32, dessen Aufbau dem des Drucksensorsystem 8 entspricht. Die Grundplatte 4 ist hier in die Wand eines Ansaugrohrs 33 des Kraftfahrzeugmotors eingebaut, so daß das Drucksensorsystem den Motor-Ansaugunterdruck erfaßt, der zum Steuern des Motors ausgewertet wird und der in der Zeichnung durch einen Pfeil 34 angedeutet ist.

## Patentansprüche

1. Steuergerät (1) in einem Kraftfahrzeug, insbesondere für ein automatisches Getriebe (28), das eine elektronische Steuerschaltung (20) aufweist, die mit mindestens einem Drucksensor (14) zum Messen des Hydraulikdrucks in dem Getriebe elektrisch verbunden ist, wobei
- der Drucksensor (14) und die elektronische Steuerschaltung (20) in einem gemeinsamen Gehäuse (2) untergebracht sind,
- das Gehäuse (2) eine metallische Grundplatte (4) aufweist, die druckdicht mit einer Hydraulikeinheit (5) des Getriebes verbunden ist,
- in die metallische Grundplatte (4) eine metallische Trägerplatte (9) für den Drucksensor (14) eingefügt ist und
- die Trägerplatte (9) für den Drucksensor (14) mit einer Bohrung (21) versehen ist, durch die der Drucksensor (14) mit dem in der Hydraulikeinheit (5) herrschenden Druck beaufschlagt wird,
**dadurch gekennzeichnet, daß** auf der in dem Gehäuse (2) liegenden Stirnfläche der Trägerplatte (9) ein metallischer Ring (10) befestigt ist, auf dem der als Siliziumchip ausgebildeter Drucksensor (14) aufgebracht ist.

2. Steuergerät (1) in einem Kraftfahrzeug, insbesondere für ein automatisches Getriebe (28), das eine elektronische Steuerschaltung (20) aufweist, die mit mindestens einem Drucksensor (14) zum Messen des Hydraulikdrucks in dem Getriebe elektrisch verbunden ist, wobei
- der Drucksensor (14) und die elektronische Steuerschaltung (20) in einem gemeinsamen Gehäuse (2) untergebracht sind,
- das Gehäuse (2) eine metallische Grundplatte (4) aufweist, die druckdicht mit einer Hydraulikeinheit (5) des Getriebes verbunden ist,
- in die metallische Grundplatte (4) eine metallische Trägerplatte (9) für den Drucksensor (14) eingefügt ist und
- die Trägerplatte (9) für den Drucksensor (14) mit einer Bohrung (21) versehen ist, durch die der Drucksensor (14)
- mit dem in der Hydraulikeinheit (5) herrschenden Druck beaufschlagt wird,
**dadurch gekennzeichnet,**
- **daß** auf der in dem Gehäuse (2) liegenden Stirnfläche der Trägerplatte (9) ein metallischer Ring (10) befestigt ist,
- **daß** auf dem metallischen Ring (10) ein Glaszylinder (12) angeordnet ist und
- **daß** auf dem Glaszylinder (12) der als Siliziumchip ausgebildete Drucksensor (14) aufgebracht ist.

3. Steuergerät nach einem der Ansprüche 1 oder 2, **dadurch gekennzeichnet, daß** die Oberfläche des metallischen Rings (10) mit einer Goldbeschichtung versehen ist.

4. Steuergerät nach einem der vorhergehenden Ansprüche, **dadurch gekennzeichnet, daß** die Grundplatte (9) gegen die Hydraulikeinheit (5) durch einen O-Ring (24) abgedichtet ist.

5. Steuergerät nach einem der vorhergehenden Ansprüche, **dadurch gekennzeichnet, daß** auf der Trägerplatte (9) ein Substrat (15) mit elektrischen Abgleichselementen (16) angeordnet ist.

6. Steuergerät nach einem der vorhergehenden Ansprüche, **dadurch gekennzeichnet, daß** die Trägerplatte (9) aus einem harten metallischen Werkstoff und die Grundplatte (4) aus einem weicheren Werkstoff besteht.

7. Steuergerät nach einem der vorhergehenden Ansprüche, **dadurch gekennzeichnet, daß** die Trägerplatte (9) aus Stahl und die Grundplatte (4) aus Aluminium besteht.

## Claims

1. Control unit (1) in a motor vehicle, in particular for an automatic gearbox (28), which has an electronic control circuit (20) which is connected electrically to at least one pressure sensor (14) for measuring the hydraulic pressure in a gearbox, where
- the pressure sensor (14) and the electronic control circuit (20) are accommodated in a common housing (2),
- the housing (2) has a metallic base plate (4) which has a pressure-tight connection with a hydraulic unit (5) on the gearbox,
- a metallic carrier plate (9) is inserted into the metallic base plate (4) for the pressure sensor (14), and
- the carrier plate (9) for the pressure sensor (14) is provided with a hole (21) through which the pressure prevailing in the hydraulic unit (5) is applied to the pressure sensor (14).
**characterised in that** a metallic ring (10), on which a pressure sensor (14) taking the form of a silicon chip is mounted, is secured to the end face of the carrier plate (9) situated in the housing (2).

2. Control unit (1) in a motor vehicle, in particular for an automatic gearbox (28), which has an electronic control circuit (20) which is connected electrically to at least one pressure sensor (14) for measuring the hydraulic pressure in a gearbox, where
- the pressure sensor (14) and the electronic control circuit (20) are accommodated in a common housing (2),
- the housing (2) has a metallic base plate (4) which has a pressure-tight connection with a hydraulic unit (5) on the gearbox,
- a metallic carrier plate (9) is inserted into the metallic base plate (4) for the pressure sensor (14), and
- the carrier plate (9) for the pressure sensor (14) is provided with a hole (21) through which the pressure prevailing in the hydraulic unit (5) is applied to the pressure sensor (14).
**characterised in that**
- a metallic ring (10) is secured to the end face of the carrier plate (9) situated in the housing (2),
- a glass cylinder (12) is located on the metallic ring (10), and
- the pressure sensor (14) taking the form of a silicon chip is mounted on the glass cylinder (12).

3. Control unit according to one of Claims 1 or 2, **characterised in that** the surface of the metallic ring (10) is provided with a gold coating.

4. Control unit according to one of the preceding claims, **characterised in that** the base plate (9) is sealed with respect to the hydraulic unit (5) by means of an O-ring (24).

5. Control unit according to one of the preceding claims, **characterised in that** a substrate (15) with electrical balancing elements (16) is located on the carrier plate (9).

6. Control unit according to one of the preceding claims, **characterised in that** the carrier plate (9) consists of a hard metallic material and the base plate (4) consists of a softer material.

7. Control unit according to one of the preceding claims, **characterised in that** the carrier plate (9) consists of steel and the base plate (4) consists of aluminium.

## Revendications

1. Appareil de commande (1) dans un véhicule automobile, en particulier pour une boîte de vitesses automatique (28), qui présente un circuit de commande électronique (20), relié électriquement à au moins un capteur de pression (14) destiné à mesurer la pression hydraulique dans la boîte de vitesses,
- le capteur de pression (14) et le circuit électronique de commande (20) étant intégrés dans un boîtier commun (2),
- le boîtier (2) présentant une plaque de base métallique (4), reliée à une unité hydraulique (5) de la. boîte de vitesses en étant étanche à la pression,
- une plaque-support (9) métallique pour le capteur de pression (14) étant intégrée dans la plaque de base métallique (4), et
- la plaque-support (9) du capteur de pression (14) étant munie d'un alésage (21), par lequel le capteur de pression (14) reçoit la pression régnant dans l'unité hydraulique (5),
**caractérisé en ce que**, sur la face frontale de la plaque de base (9), située dans le boîtier (2), est fixé un anneau métallique (10), sur lequel est installé le capteur de pression (14), réalisé sous la forme d'une puce de silicium.

2. Appareil de commande (1) dans un véhicule automobile, en particulier pour une boîte de vitesses automatique (28), qui présente un circuit de commande électronique (20), relié électriquement à au moins un capteur de pression (14) destiné à mesurer la pression hydraulique dans la boîte de vitesses,
- le capteur de pression (14) et le circuit électronique de commande (20) étant intégrés dans un boîtier commun (2),
- le boîtier (2) présentant une plaque de base métallique (4), reliée à une unité hydraulique (5) de la boîte de vitesses en étant étanche à la pression, - une boîte de vitesses en étant étanche à la pression, - une plaque-support (9) métallique pour le capteur de pression (14) étant intégrée dans la plaque de base métallique (4), et
- la plaque-support (9) du capteur de pression (14) étant munie d'un alésage (21), par lequel le capteur de pression (14) reçoit la pression régnant dans l'unité hydraulique (5),
**caractérisé,**
- **en ce que**, sur la face frontale de la plaque de base (9), située dans le boîtier (2), est fixé un anneau métallique (10),
- **en ce que**, sur l'anneau métallique (10), est disposé un cylindre de verre (12), et
- **en ce que**, sur le cylindre de verre (12), est appliqué le capteur de pression (14), réalisé sous la forme d'une puce de silicium.

3. Appareil de commande suivant l'une de revendications 1 ou 2, **caractérisé en ce que** la surface externe de l'anneau métallique (10) est revêtue d'une couche d'or.

4. Appareil de commande suivant l'une des revendications précédentes, **caractérisé en ce que** la plaque de base (9) est rendue étanche par rapport à l'unité hydraulique (5) au moyen d'un joint torique (24).

5. Appareil de commande suivant l'une des revendications précédentes, **caractérisé en ce que**, sur la plaque-support (9), est disposé un substrat (15) comportant des éléments d'ajustement (16) électriques.

6. Appareil de commande suivant l'une des revendications précédentes, **caractérisé en ce que** la plaque-support (9) est constituée d'un matériau métallique dur et **en ce que** la plaque de base (4) est constituée d'un matériau plus tendre.

7. Appareil de commande suivant l'une des revendications précédentes, **caractérisé en ce que** la plaque-support (9) est constituée d'acier et la plaque de base métallique (4) est constituée d'aluminium.
